# EUROPEAN PATENT APPLICATION

(11) **EP 0 849 790 A1**
(43) Date of publication of application: **24.06.1998**
(21) Application number: 97121970.4
(22) Date of filing: 13.12.1997
(51) Int. Cl.: H01L 21/8239, H01L 27/105

(54) **Non-volatile semiconductor memory cell with peripheral transistors**

(30) Priority: 16.12.1996 US 33369 P
(71) Applicant: Texas Instruments Incorporated, Dallas, Texas 75265 (US)
(72) Inventor: McElroy, David J., Allen, TX 75002 (US)
(74) Representative: Holt, Michael

(57) **Abstract**

A method for forming a nonvolatile memory cell (10) includes the steps of forming an array area (12), an N-channel periphery (20), a P-channel periphery (24) and a polysilicon 1 layer slot area pattern (18). Patterning a stack transistor (40) in array area (12) without removing photoresist (52) from N-channel periphery (20) and P-channel periphery (24) is another step of the present method. The method then includes patterning N-channel region (60) without removing photoresist (52) from P-channel periphery (24). Applying photoresist (74) to the stack transistor (40) and N-channel region (60), as well as over a predetermined portion of P-channel periphery (24) for forming P-channel region (70) then occurs. Then, P-channel region (70) may be formed in the P-channel periphery (24). Contacts and protective oxide (90, 92) may then cover stack transistor (40), N-channel region (60), and P-channel region (70).

## Description

### TECHNICAL FIELD OF THE INVENTION

The present invention relates to semiconductor devices and, more particularly, to a method for forming a nonvolatile memory cell and the memory cell resulting therefrom.

### BACKGROUND OF THE INVENTION

Reducing the number of steps in methods for forming semiconductor memory device cells, such as non-volatile memory cells, is often attractive and economically beneficial. This is especially true in instances where no degradation or compromise of the resulting memory cell results. Accordingly, efforts are continually being made to shorten memory cell fabrication processes.

One particularly important part of the memory cell formation process involves the use of photolithographic masks for defining the physical structures that compose the stack transistors, N-channel devices and P-channel devices of the memory cell. Forming the masks for a non-volatile memory cell, however, requires the numerous steps of depositing a mask, etching through the mask, and removing the mask. If it were possible to reduce the number of masks required to form a non-volatile memory cell, then the fabrication costs and time could be significantly reduced.

### SUMMARY OF THE INVENTION

Therefore, a need has arisen for an improved method for forming a non-volatile memory cell which reduces the number of masks required to form the memory cell.

A need has arisen for an improved memory cell fabrication method that permits the simple formation of the stack transistor, the N-channel devices, and P-channel devices of a non-volatile memory cell that reduces the number of masks required to achieve this result.

In accordance with the present invention, an improved method for forming a nonvolatile memory cell is provided that substantially reduces disadvantages and problems associated with previously developed non-volatile memory cell formation methods.

According to an aspect of the present invention, there is provided, a method for forming a non-volatile memory cell that includes the step of forming an array area, an N-channel periphery, a P-channel periphery, and a polysilicon 1 layer slot area pattern. Then, the method includes a gate oxide/interlevel oxide layer formation step, followed by polysilicon 2 layer deposition and tungsten silicide layer deposition steps. A photoresist layer is then formed over the device. A stack transistor is then patterned in the array area without removing the photoresist from the N-channel and P-channel areas. The array area surrounding the stack is subjected to a heavy arsenic doping. The N-channel region is then patterned without removing the photoresist from the P-channel periphery and array. A phosphorous implant for the lightly-doped drain then occurs. A spacer is then deposited and the source/drain area is doped with an arsenic implant. Then, a side-wall oxidation takes place. Photoresist is then applied to the stack transistor and N-channel, as well as over the P-channel periphery. The P-channel region is then patterned and at least some degree of undercutting may occur on the polysilicon and boron is then implanted. Furthermore, a protective oxide layer is formed over the structure to yield a finished nonvolatile memory cell.

A technical advantage of the present invention is that it avoids the need for masks to block the implant regions during N-channel and P-channel formation. This reduces the number of required masks by two or more masks. The present invention avoids the need that prior art devices have for a photoresist mask to pattern the P-channel and a shield mask for shielding the additional P-channel during the N-channel implant and a mask to protect the periphery during the array implant.

Another technical advantage of the present invention is that it permits forming the stack transistor without removing the photoresist from the whole nonvolatile memory cell area. The result is a cleaner and faster nonvolatile memory cell fabrication process.

### BRIEF DESCRIPTION OF THE DRAWINGS

For a more complete understanding of the present invention and the advantages thereof, reference is now made to the following description which is to be taken in conjunction with the accompanying drawings in which like reference numerals indicate like features and wherein:
FIGURE 1 shows a structure according to the present invention at a stage for forming an array region N-channel periphery, a P-channel periphery, and a polysilicon 1 layer for a slot region;
FIGURE 2 illustrates steps of a method according to the present invention including growing and/or depositing a gate oxide/interlevel oxide layer, a polysilicon 2 layer, and a tungsten silicide layer;
FIGURE 3 provides a cross-sectional view of a stack transistor formation formed according to the present invention;
FIGURE 4 depicts the formation of an N-channel polysilicon 2 layer pattern according to a process of the present invention;
FIGURE 5 shows a P-channel polysilicon 2 layer pattern formed according to the present invention; and
FIGURE 6 provides a cross-section of a structure resulting from the contact pattern steps, metal removal pattern, and protective oxide pattern steps of a method of the present invention.

### DETAILED DESCRIPTION OF THE INVENTION

Preferred embodiments of the present invention are illustrated in the FIGUREs like numerals being used to refer to like and corresponding parts of the various drawings.

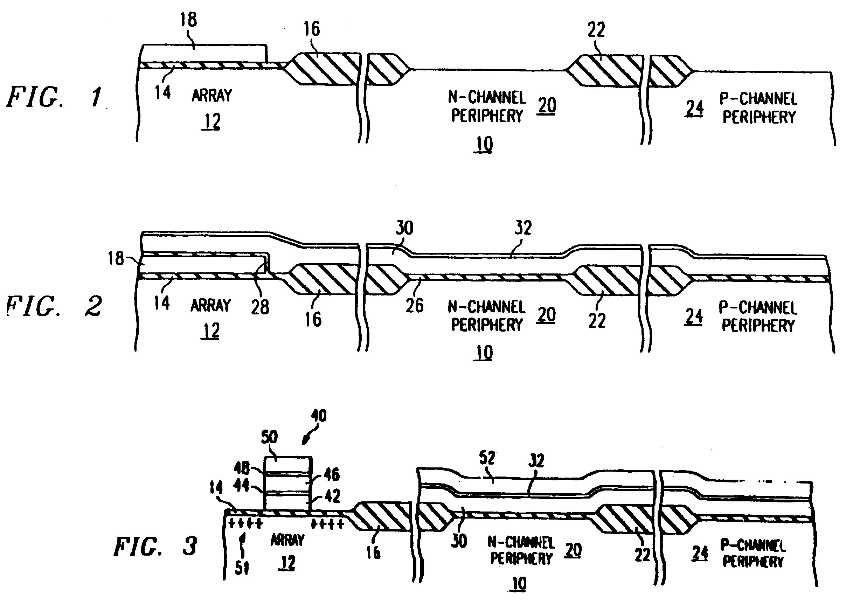

FIGURE 1 shows a structure at the stage of forming array region an N-channel periphery region, a P-channel periphery region, and a polysilicon 1 layer. FIGURE 1 shows that in substrate 10 array region, array region 12 is covered by gate oxide layer 14 that contacts LOCOS region 16. Polysilicon 1 layer 18 covers a portion of first gate oxide layer 14. LOCOS region 16 continues until N-channel periphery region 20 of substrate 10. N-Channel periphery region 20 continues until LOCOS region 22, which itself continues until P-channel periphery region 24.

In forming the structure of FIGURE 1, a first step is to lay a pad oxide layer followed by depositing a nitride 1 layer. For the N-well pattern, first steps are to perform a nitride etch in the area of the N-well, then a phosphorus implant, followed by a clean-up step. Optionally, a deglaze may take place to remove phosphorus doped oxide and an optional arsenic implant. This step improves the VT_{F} threshold voltage of the parasitic transistor for the polysilicon layer over the thick oxide layer without an extra channel stop mask. The steam oxide step drives in the phosphorus or arsenic implant growing oxide on the N layer. This provides a self-aligned oxide that blocks the subsequent boron P-well implant from the area to pattern P-channel region. A nitride strip step next occurs, followed by a boron implant. Another steam oxide step occurs to drive in the boron implant. The next step is a strip tank oxide step. Thereafter, a pad oxide process occurs, followed by a nitride 2 layer deposition.

In forming the moat, a first step is to etch the nitride layer followed by an optional CS mask step. Then, a boron implant step occurs for the purpose of adjusting the V_{T}. A cleanup step may occur next. Then, a field oxide process occurs followed by a nitride strip process. A V_{SS} optional mask step may occur next. This includes an optional V_{T} implant, followed by a strip oxide step. Then the gate oxide layer 14 is grown. Polysilicon 1 layer 18 deposition then occurs with an optional in-situ doping step. Furthermore, an optional POCl₃ doping step may occur if the in-situ doping does not take place.

Polysilicon 1 layer 18 patterning step occurs next to form the slot region. The polysilicon 1 layer 18 etch may take place, followed by a cleanup step. The result is the structure shown in FIGURE 1.

FIGURE 2 illustrates the results of the steps of a method that includes growing a gate oxide/interlevel oxide layer, a polysilicon 2 layer, and a tungsten silicide (WSi_{X}) layer. The structure of FIGURE 2 results from growth of a second gate oxide/interlayer level 26 that joins LOCOS regions 16 and 22. Gate oxide region 2 takes the form of an interlevel oxide region 28 for polysilicon 1 layer 18 in array region 12. Polysilicon 2 layer 30 covers all of interlevel oxide layer 28 and oxide layer 26. WSi_{X} layer 32 covers polysilicon 2 layer 30. In forming the structure of FIGURE 2, interlevel oxide (layer 28) is grown on polysilicon 1 layer 18 at the same time that gate oxide (region 2) is grown in the N-channel periphery and P-channel periphery. Polysilicon 2 layer 30 deposition takes place, followed by deposition of tungsten silicide (WSiₓ)layer 32. Although not shown, optionally a top oxide may be deposited to encapsulate the stack transistor after a side wall oxide etch step.

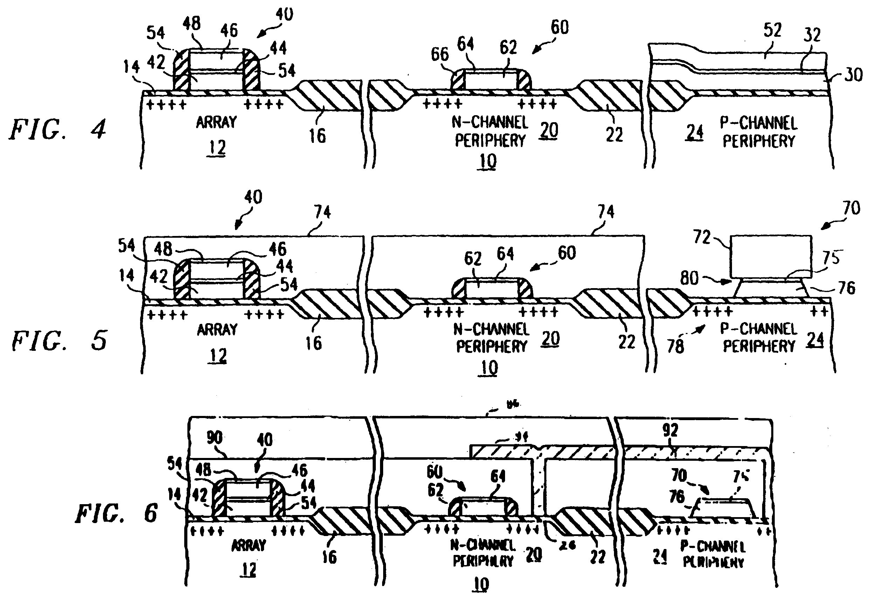

FIGURE 3 shows array region 12 that includes stack transistor 40. Stack transistor 40 includes polysilicon 1 segment 42 covering gate oxide layer 14. Interlevel oxide segment 44 is formed from interlevel oxide layer 28. Polysilicon 2 segment 46 is formed from polysilicon 2 layer 30. Tungsten silicide segment 48 is formed from tungsten silicide layer 32. Photoresist portion 50 covers and protects the underlying layers of transistor 40. Photoresist layer 52 also covers tungsten silicide layer 42. Array region 12 also receives arsenic doping for the proper operation of stack transistor 40 as "+" signs 51 indicate.

Forming the stack pattern transistor of FIGURE 3 includes a stack etch step. This includes etching tungsten silicide layer 32, polysilicon 2 layer 30, interlevel oxide layer 28, and polysilicon 1 layer 18. Optionally, a cap oxide deposition or growth step may occur. Next, an optional boron implant may occur. Boron may be implanted outside the stack, and driven under the edges to set V_{T} of the nonvolatile memory cell. A next step is an ASD (array-source/drain) arsenic implant to a density of approximately 5E15 atoms/cm². Optionally, after the ASD implant, photoresist may be removed if a "predrive" of boron is desired. Then a blanket arsenic implant can be performed. A cleanup step next occurs, followed by optional implant drive step. For flash devices that use a source-side erase, an additional pattern opening may be formed on only one side of the stack and the phosphorus implant is inserted at this point. Then, an optional drive step may occur. This may be desirable, for example, to produce a deep diffusion in the source side of stack transistor 40. A cleanup step may occur afterwards.

FIGURE 4 shows the structure resulting from forming N-channel polysilicon 2 pattern. In FIGURE 4, N-channel periphery region 20 includes N-channel device 60 includes polysilicon 2 portion 62 formed from polysilicon layer 30. Tungsten silicide portion 64 is formed from tungsten silicide layer 32. N-channel periphery 20, as indicated by the associated "+" signs, also receives a phosphorus implant. The formation of the N-channel polysilicon 2 layer pattern for the FIGURE 4 structure begins by etching polysilicon 2 layer 30 and the tungsten silicide layer 32. Then an LDD phosphorus implant occurs. A side-wall oxide deposition occurs next, followed by side-wall oxide etch. An optional phosphorus implant may occur next or after the following arsenic implant. This occurs, however, after the side-wall oxide deposition step. Finally, an N-channel source/drain implant of arsenic occurs.

The process yielding the N-channel pattern of FIGURE 4 makes use of a innovative aspect that separately patterns the N-channel device and the P-channel device. The N-channel device is patterned while photoresist layer 52 remains on P-channel periphery 24. Stack transistor 40 includes sidewall oxide layer 54, and N-channel device 60 further includes a sidewall oxide layer 66.

FIGURE 5 shows the P-channel polysilicon pattern within the structure of the present embodiment. In particular, P-channel device 70 is formed using photoresist pattern 72 which is part of the patterned photoresist layer 74 that covers array region 12 and N-channel periphery region 20. Beneath photoresist pattern 72 is P-channel device 70 that includes tungsten silicide segment 74, covering polysilicon 2 layer 76. Gate oxide layer 30 is beneath polysilicon 2 layer 76 and receives a boron implant as indicated by "+" signs 78. During the etch of polysilicon pattern 76 and tungsten silicide pattern 75, a small degree of undercut forming undercut region 80 results. Forming the structure of FIGURE 5 begins by etching polysilicon 2 layer 30. The undercutting etch causes photoresist segment 72 to overhang the edges of the P-channel polysilicon 2 segment 76 to offset the PSD implant. Then, a P-channel source/drain implant of boron takes place to a density of approximately 5EE14 atoms/cm². A cleanup step may then occur. Optionally, after removal of photoresist, an additional boron implant can be performed. This takes advantage of the sloped P-channel polysilicon 2 layer side-walls and gives a profile to the boron that penetrates the sides of the polysilicon layer. Even if energy is low enough so that little or no penetration of the gate edge takes place, the overlapped region, which is not implanted, can now be implanted with a lighter dose to form a lightly-doped drain.

FIGURE 6 provides a cross-section of a structure resulting from the contact patterning, metal removal patterning, and protective oxide patterning stages.

The structure of FIGURE 6 includes multi-level oxide (MLO) layer 90 that covers stack transistor 40 within array region 12 and N-channel device 60 within N-channel periphery 20. MLO region 92 covers P-channel device 70 within P-channel periphery 24. Metal layer 92 covers part of protective oxide layer 92, and contacts oxide layer 26. Protective oxide layer covers protective oxide layer 90 and metal layer 94.

A first step in forming the structure of FIGURE 6 is to perform a MLO deposition. A next optional step is to planarize the MLO. This sets the stage for performing the contact patterning. The contact patterning is the step of etching the contacts and is followed by cleanup step. Deposition of the metal-sticking layer, for example, titanium, occurs next. An optional anneal may occur afterward. Then, a metal deposition to deposit titanium, tungsten and/or aluminum, or some other metal may take place.

For metal removal patterning, the metal etch occurs first, followed by a cleanup step. For the double level metal, the via patterning occurs first, followed by the etch of the via and a cleanup. Afterward, a metal 2 system deposition occurs. Metal 2 system patterning may occur next to effect the etching of the MLO layer. Thereafter, a cleanup step occurs. Metalization removal patterning is completed by depositing a protective oxide deposition. Protective oxide patterning occurs as the result of protective oxide etch from the pads and an optional laser fuses. The result, therefore, is a nonvolatile memory cell formed with at least two fewer steps than that required by prior art processes.

Although the invention has been described in detail herein with reference to certain illustrative embodiments, it is to be understood that this description is by way of example only and is not to be construed in a limiting sense. It is to be further understood, therefore, that numerous changes in the details of the embodiments of the invention and additional embodiments of the invention, will be apparent to, and may be made by, persons of ordinary skill in the art having reference to this description.

## Claims

1. A method of forming a non-volatile memory cell comprising:
forming an array area, an N-channel periphery, a P-channel periphery and a polysilicon 1 layer slot area pattern;
patterning a stack transistor in the array area while substantially retaining the photoresist from the N-channel periphery and P-channel periphery;
patterning the N-channel region while substantially retaining the photoresist from the P-channel periphery and said array area;
patterning photoresist over the stack transistor and N-channel region, as well as patterning the P-channel periphery for forming the P-channel region; and
forming a P-channel region in the P-channel periphery.

2. The method of Claim 1, further comprising the steps of, prior to patterning said stack transistor, forming a gate oxide/interlevel oxide layer;
forming a polysilicon 2 layer;
forming a tungsten silicide layer; and
forming a photoresist layer over the device.

3. The method of Claim 1 or Claim 2, further comprising the step of, prior to forming said N-channel region, doping an array area substantially surrounding the stack transistor.

4. The method of any of Claims 1 to 3, further comprising the step of, prior to forming said P-channel region, performing the steps of implanting the N-channel region with a phosphorous implant for forming a lightly-doped drain and forming a side-wall oxidation layer on the N-channel region and stack transistor.

5. The method of any of Claims 1 to 4, further comprising the step of forming at least one protective oxide layer over the stack transistor, the N-channel region, and the P-channel region.

6. A method of forming a nonvolatile memory cell comprising:
forming an array area, an N-channel periphery, a P-channel periphery and a polysilicon 1 layer slot area pattern;
forming a gate oxide/interlevel oxide layer;
forming a polysilicon 2 layer;
forming a tungsten silicide layer;
forming a photoresist layer over the device;
patterning a stack transistor in the array area while substantially retaining the photoresist from the N-channel and P-channel areas;
doping the array area surrounding the stack transistor;
patterning the N-channel region while substantially retaining the photoresist from the P-channel periphery;
implanting the N-channel region with a phosphorous implant for forming a lightly-doped drain;
forming a side-wall oxidation layer on the N-channel region and stack transistor;
applying photoresist to the stack transistor and N-channel region, as well as over a predetermined portion of the P-channel periphery for forming the P-channel region; and
forming the P-channel region.

7. A nonvolatile memory cell comprising:
an array area;
an N-channel periphery;
a P-channel periphery;
a stack transistor formed by the steps of patterning a stack transistor in the array area while substantially retaining the photoresist from the N-channel periphery and P-channel periphery and doping the array area surrounding the stack transistor;
an N-channel region formed by patterning the N-channel region while substantially retaining the photoresist from the P-channel periphery;
a P-channel region formed by applying photoresist to the stack transistor and N-channel region, as well as over a predetermined portion of the P-channel periphery for forming the P-channel region and forming the P-channel region.

8. The nonvolatile memory cell of Claim 7, wherein said stack transistor further comprises:
a polysilicon 1 layer slot area pattern formed in said array area;
a gate oxide/interlevel oxide layer
a polysilicon 2 layer;
a tungsten silicide layer; and
a photoresist layer formed over the device.

9. The nonvolatile memory cell of Claim 7 or Claim 8, wherein said N-channel region further comprises:
an N-channel region implanted with a phosphorous implant for forming a lightly-doped drain; and
a side-wall oxidation layer formed on the N-channel region and stack transistor.

10. The nonvolatile memory cell of any of Claims 7 to 9, further comprising at least one protective oxide layer formed over the stack transistor, the N-channel region, and the P-channel region.

11. A nonvolatile memory cell comprising:
an array area;
an N-channel periphery;
a P-channel periphery;
a stack transistor comprising:
a polysilicon 1 layer slot area pattern formed in said array area;
a gate oxide/interlevel oxide layer;
a polysilicon 2 layer;
a tungsten silicide layer;
a photoresist layer formed over the device;
patterning a stack transistor in the array area while substantially retaining the photoresist from the N-channel periphery and P-channel periphery; and
a doped array area surrounding the stack transistor;
an N-channel region comprising:
a first N-channel region formed while substantially retaining the photoresist from the P-channel periphery or array area;
a second N-channel region implanted with a phosphorous implant for forming a lightly-doped drain;
a side-wall oxidation layer formed on the N-channel region and stack transistor; and
a P-channel region comprising:
a photoresist applied to the stack transistor and N-channel region, as well as over a predetermined portion of the P-channel periphery for forming the P-channel region;
the P-channel region; and
at least one protective oxide layer formed over the stack transistor, the N-channel region, and the P-channel region.
